# EUROPEAN PATENT APPLICATION

(11) **EP 4 518 016 A1**
(43) Date of publication of application: **05.03.2025**
(21) Application number: 22946224.7
(22) Date of filing: 16.06.2022
(51) Int. Cl.: H01M 50/593, H01M 50/591, C23C 16/40

(54) **BATTERY COMPONENT PROTECTION METHOD AND DEVICE, SECONDARY BATTERY, BATTERY MODULE, BATTERY PACK, AND ELECTRIC APPARATUS**

(71) Applicant: Contemporary Amperex Technology (Hong Kong) Limited, Central, Central And Western District (HK)
(72) Inventor: LI, Ting, Ningde, Fujian 352100 (CN); JIN, Haizu, Ningde, Fujian 352100 (CN); NIU, Shaojun, Ningde, Fujian 352100 (CN); TANG, Huaichao, Ningde, Fujian 352100 (CN); PENG, Longqing, Ningde, Fujian 352100 (CN)
(74) Representative: Gong, Jinping
(86) International application number: PCT/CN2022/099136
(87) International publication number: WO 2023/240530

(57) **Abstract**

This application relates to a protection method for battery components that include an electrode assembly and a top cap assembly. The method includes: step (1): putting the battery components into a cavity, and vacuumizing the cavity to 100 kPa or below, optionally, 100 Pa or below; step (2): introducing a first reactant into the cavity until a pressure rises by 1 Pa or above, and optionally, rises by 1 kPa or above, and keeping the pressure for 1 ms or above, optionally, 0.1 s to 600 s; and optionally, step (3): vacuumizing the cavity to 100 kPa or below, optionally, 100 Pa or below; and step (4): introducing a second reactant into the cavity until a pressure rises by 1 Pa or above, and optionally, rises by 1 kPa or above, and keeping the pressure for 1 ms or above, optionally, 0.1 s to 600 s, so that protective layers are formed on surfaces of the battery components. This application further relates to a protection device for the battery components, a secondary battery, a battery module, a battery pack, and an electrical apparatus.

## Description

### TECHNICAL FIELD

This application relates to the technical field of secondary batteries, and in particular, to a protection method and device for battery components, a secondary battery, a battery module, a battery pack, and an electrical apparatus.

### BACKGROUND

In recent years, as the application range of secondary batteries becomes more and more extensive, the secondary batteries are widely applied to energy storage power supply systems such as hydraulic, thermal, wind and solar power plants, as well as fields of electric tools, electric bicycles, electric motorcycles, electric vehicles, military equipment, aerospace, and the like. Because of the great development of the secondary batteries, higher requirements have been put forward for their energy densities, cycle performance, safety performance, and the like. However, the safety performance of the existing secondary batteries still needs to be improved.

### SUMMARY

This application is made in view of the foregoing subject matter, and the objective of this application is to provide a protection method for battery components including an electrode assembly and a top cap assembly, which can simultaneously form protection layers on surfaces of the battery components, especially on an inner wall of the top cap assembly, and a weld of the electrode assembly and the top cap assembly, thereby reducing the probability of corrosion and short circuiting of a secondary battery.

In order to achieve the above objective, this application provides a protection method and device for battery components including an electrode assembly and a top cap assembly, a secondary battery, a battery module, a battery pack, and an electrical apparatus.

A first aspect of this application provides a protection method for battery components. The battery components include an electrode assembly and a top cap assembly, and the method includes:
step (1): putting the battery components into a cavity, and vacuumizing the cavity to 100 kPa or below, optionally, 100 Pa or below;
step (2): introducing a first reactant into the cavity until a pressure rises by 1 Pa or above, and optionally, rises by 1 kPa or above, and keeping the pressure for 1 ms or above, optionally, 0.1 s to 600 s; and optionally,
step (3): vacuumizing the cavity to 100 kPa or below, optionally, 100 Pa or below; and
step (4): introducing a second reactant into the cavity until a pressure rises by 1 Pa or above, and optionally, rises by 1 kPa or above, and keeping the pressure for 1 ms or above, optionally, 0.1 s to 600 s,
so that protective layers are formed on surfaces of the battery components,
where the second reactant can react with the first reactant to form the protective layers.

Thus, in this application, the battery components including the electrode assembly and the top cap assembly are protected through a gas-solid interface reaction technology, the protective layers are simultaneously formed on surfaces of the battery components, especially on an inner wall of the top cap assembly, and a weld of the electrode assembly and the top cap assembly, which can reduce the probability of corrosion and short circuiting of a secondary battery, thereby improving safety performance and corrosion resistant performance of the secondary battery.

In an optional implementation, the first reactant includes at least one of a gaseous aluminum compound, silicon compound, tin compound, germanium compound, chromium compound, boron compound, titanium compound, vanadium compound, zinc elementary substance, zinc compound, zirconium compound, hafnium compound and tantalum compound; and optionally, includes at least one of gaseous AlCl₃, trimethylaluminum, Al(CH₃)₂Cl, Al(C₂H₃)₃, Al(OC₂H₃)₃, (CH₃)₂AlOCH(CH₃)₂, (CH₃CH₂)₂AlOC₂H₃, Al(CH₃)₂OC₂H₃, Al(N(C₂H₅)₂)₃, Al(N(CH₃)₂)₃, SiCl₄, SiCl₂H₂, Si₂Cl₆, Si(OC₂H₅)₂H₂, Si₂H₆, Si(OCH₂CH₃)₄, Si(OCH₃)₄, SiH(OCH₃)₃, SiH(OC₂H₃)₃, (CH₃)₂Si(OCH₃)₂, Si(NCO)₄, Si(OC₂H₃)₄, H₂N(CH₂)₃Si(OC₂H₅)₃, CH₂=CHSi(OCH₃)₃, (CH₂=CH)₃SiOCH₃, ((CH₃)₃CO)₃SiOH, (CH₃CH₂C(CH₃)₂O)₃SiOH, SiH[N(CH₃)₂]₃, SiH₂[N(CH₃)₂]₂, SiH₂[NH(C₄H₉)]₂, SiH₂[N(C₂H₅)₂]₂, SiH₂[NC₂H₅CH₃]₂, SiH₃N(C₄H₉)₂, [Si(NHC₂H₃)₃]₂, Si(NHC₂H₅)₄, SiH₃N(C₃H₇)₂, [SiH₂N(C₃H₇)₂]₂, Si(N(CH₃)₂)₄, (CH₃)₃SiN(CH₃)₂, C₇H₁₇NSi, C₈H₂₀N₂Si, C₈H₁₇NO₂Si, C₇H₁₈N₂O₂Si, SiCl₃H, SnCl₄, GeCl₃, CrO₂Cl₂, BBr₃, TiF₄, TiCl₄, TiI₄, Ti(OCH₃)₄, Ti(OC₂H₅)₄, Ti(N(CH₃)₂)₄, Ti(N(C₂H₅)₂)₄, Ti(N(CH₃)(C₂H₅))₄, VOCl₃, Zn, ZnCl₂, Zn(CH₃)₂, Zn(C₂H₅)₂, ZnI₂, ZrCl₄, ZrI₄, Zr(N(CH₃)₂)₄, Zr(N(C₂H₅)₂)₄, Zr(N(CH₃)(C₂H₅))₄, HfCl₄, HfI₄, Hf(NO₃)₄, Hf(N(CH₃)(C₂H₃))₄, Hf(N(CH₃)₂)₄, Hf(N(C₂H₅)₂)₄, TaCl₅, TaF₃, TaI₅, Ta(O(C₂H₅))₅, Ta(N(CH₃)₂)₅, Ta(N(C₂H₅)₂)₅ and TaBr₅.

In an optional implementation, the second reactant includes at least one of, and/or plasma of at least one of H₂O, O₂, O₃, H₂, S, (NH₄)₂S, H₂Se, Se, H₂Te, Te, HF, TiF₄, TaF₃, C₂H₄, CHCl₃, H₂O₂, NO₂, N₂O, NH₃, N₂H₄, HCOOH, CH₃COOH and H₂S.

By selecting the first reactant and the second reactant, the ingredients of the protective layers may be controlled, and the protective layers are uniform and dense, and have a strong bonding force with substrates, thereby reducing the probability of corrosion and short circuiting of the secondary battery.

In an optional implementation, in steps (1) to (4), a temperature of the cavity is maintained between 0°C and 200°C. The temperature of the cavity is maintained within a given range, and thus adapted to physical property parameters of specific reactants.

In an optional implementation, steps (1) to (4) are repeated 1 to 100,000 times. By controlling the times of repetition of steps (1) to (4), a thickness of the protective layers may be controlled.

In an optional implementation, steps (1) to (2) are first repeated 1 to 10 times, and then steps (1) to (4) are repeated 1 to 100,000 times. Thus, water of the battery components may be fully utilized as a reactant.

In an optional implementation, the first reactant and the second reactant are introduced by a carrier gas, and the carrier gas includes at least one of nitrogen, argon, carbon dioxide and helium. By introducing the first reactant and the second reactant through the carrier gas, the reactants may enter the cavity more smoothly.

In an optional implementation, prior to step (1), the protection method further includes a step of pretreating surfaces of the battery components, the step including introducing at least one of, and/or plasma of at least one of Ar, N₂, H₂O, O₂, O₃, H₂, S, (NH₄)₂S, H₂Se, Se, H₂Te, Te, HF, TiF₄, TaF₅, C₂H₄, CHCl₃, H₂O₂, NO₂, N₂O, NH₃, N₂H₄, HCOOH, CH₃COOH and H₂S into the cavity. Through the step of pretreating, the bonding force between the protective layers and the substrates may be increased.

In an optional implementation, the battery components further include tabs and adapter plates, and the protective layers are formed at junctions of the tabs and the adapter plates, junctions of the adapter plates and the top cap assembly, an inner wall of the top cap assembly, the adapter plates, and a peripheral surface of the electrode assembly. On the one hand, the protective layers may cover the peripheral surface of the electrode assembly, including defects such as burrs and protruding points, thereby reducing potential safety hazards; and on the other hand, the protective layers may cover the inner wall of the top cap assembly, thereby preventing corrosion.

In an optional implementation, the protective layers include at least one of carbides, nitrides, sulfides, oxides, fluorides, selenides and tellurides of aluminum, silicon, tin, germanium, chromium, boron, titanium, vanadium, zinc, zirconium, hafnium or tantalum, and optionally include at least one of aluminum oxides, silicon oxides, silicon nitrides, titanium oxides and zinc oxides. By controlling the composition of the protective layers, the protective layers may be more uniform and denser, and the bonding force between the protective layers and the substrates is increased.

In an optional implementation, after step (2) and/or step (4), the protection method further includes a step of purging the battery components using a purging gas, the purging gas including at least one of N₂, Ar, He, CO₂ and the second reactant. Through the step of purging, the purity and bonding force of the protection layers may be further increased.

In an optional implementation, the protective layers have a thickness ranging from 1 nm to 1000 µm, optionally, 50 nm to 500 nm. By controlling the protective layers within an appropriate thickness range, it has almost no effect on the overall mass energy density and volume energy density of the secondary battery while providing insulation protection.

In an optional implementation, the protection method further includes a step of aftertreating the protective layers, the step including temperature annealing treatment, plasma annealing treatment or optical radiation annealing treatment in a specific atmosphere; and the specific atmosphere includes at least one of, and/or plasma of at least one of pyridine, N₂, Ar, He, CO₂ and the second reactant. Through the step of aftertreating, the quality of the protective layers may be further improved.

A second aspect of this application further provides a protection device for battery components. The battery components include an electrode assembly and a top cap assembly, and the protection device includes:
a cavity, configured to accommodate the battery components;
a first reactant tank, configured to store a first reactant;
a second reactant tank, configured to store a second reactant;
a vacuum pump;
a pressure gauge, configured to detect a pressure of the cavity in real time; and
a flow adjustment valve, configured to adjust flows of the first reactant and the second reactant,
where the second reactant can react with the first reactant to form protective layers;
the first reactant tank and the second reactant tank communicate with the cavity respectively to introduce the first reactant and the second reactant into the cavity; and the vacuum pump communicates with the cavity to vacuumize the cavity.

Thus, protective reaction requirements may be realized, and the device is simple, thereby simplifying a protection process of the battery components, which may improve the efficiency, and at the same time, may reduce costs, thereby facilitating industrialized production.

A third aspect of this application provides a secondary battery. The secondary battery includes battery components obtained by protection through the protection method according to the first aspect of this application.

A fourth aspect of this application provides a battery module. The battery module includes the secondary battery according to the third aspect of this application.

A fifth aspect of this application provides a battery pack. The battery pack includes the battery module according to the fourth aspect of this application.

A sixth aspect of this application provides an electrical apparatus. The electrical apparatus includes at least one of the secondary battery according to the third aspect of this application, the battery module according to the fourth aspect of this application, or the battery pack according to the fifth aspect of this application.

The battery module, battery pack and electrical apparatus of this application include the secondary battery of this application, and thus at least have the same advantages as the secondary battery.

### BRIEF DESCRIPTION OF DRAWINGS

FIG. 1 is an exploded view of battery components according to an implementation of this application.
FIG. 2 is a schematic diagram of a secondary battery according to an implementation of this application.
FIG. 3 is a schematic diagram of a battery module according to an implementation of this application.
FIG. 4 is a schematic diagram of a battery pack according to an implementation of this application.
FIG. 5 is an exploded view of the battery pack shown in FIG. 4 according to an implementation of this application.
FIG. 6 is a schematic diagram of an electrical apparatus using a secondary battery as a power supply according to an implementation of this application.

### DETAILED DESCRIPTION OF EMBODIMENTS

The following describes in detail and specifically discloses implementations of a protection method and device for battery components, a secondary battery, a battery module, a battery pack, and an electrical apparatus according to this application with due reference to drawings. However, unnecessary details may be omitted in some cases. For example, a detailed description of a well-known matter or repeated description of an essentially identical structure may be omitted. That is intended to prevent the following descriptions from becoming unnecessarily lengthy, and to facilitate understanding by a person skilled in the art. In addition, the drawings and the following descriptions are intended for a person skilled in the art to thoroughly understand this application, but not intended to limit the subject matter recited in the claims.

A "range" disclosed in this application is defined in the form of a lower limit and an upper limit. A given range is defined by a lower limit and an upper limit selected. The selected lower and upper limits define boundaries of a particular range. A range so defined may be inclusive or exclusive of end values, and a lower limit of one range may be arbitrarily combined with an upper limit of another range to form a range. For example, if a given parameter falls within a range of 60 to 120 and a range of 80 to 110, it is expectable that the parameter may fall within a range of 60 to 110 and a range of 80 to 120 as well. In addition, if lower-limit values 1 and 2 are listed, and if upper-limit values 3, 4 and 5 are listed, the following ranges are all expectable: 1 to 3, 1 to 4, 1 to 5, 2 to 3, 2 to 4, and 2 to 5. Unless otherwise specified in this application, a numerical range "a to b" is a brief representation of any combination of real numbers between a and b inclusive, where both a and b are real numbers. For example, a numerical range "0 to 5" herein means all real numbers listed between 0 and 5 inclusive, and the expression "0 to 5" is just a brief representation of a combination of such numbers. In addition, a statement that a parameter is an integer greater than or equal to 2 is equivalent to a disclosure that the parameter is an integer such as 2, 3, 4, 5, 6, 7, 8, 9, 10, 11, 12, and so on.

Unless otherwise expressly specified, any implementations and optional implementations in this application may be combined with each other to form a new technical solution.

Unless otherwise expressly specified, any technical features and optional technical features in this application may be combined with each other to form a new technical solution.

Unless otherwise expressly specified, all steps in this application may be performed in sequence or at random, and preferably in sequence. For example, that the method includes steps (a) and (b) indicates that the method may include steps (a) and (b) performed in sequence, or steps (b) and (a) performed in sequence. For example, when it is mentioned that the method may further include step (c), it indicates that step (c) may be added into the method in any sequence. For example, the method may include steps (a), (b), and (c), or may include steps (a), (c), and (b), or may include steps (c), (a), and (b), and so on.

Unless otherwise expressly specified, "include" and "comprise" referred to in this application may be open-ended, or close-ended. For example, the "include" and "comprise" may indicate that other components not listed may also be included or comprised, or that only the listed components may be included or comprised.

Unless otherwise expressly specified, in this application, the term "or" is inclusive. For instance, the phrase "A or B" means "A, B, or both A and B". More specifically, any one of the following conditions satisfies the condition "A or B": A is true (or exists) and B is false (or does not exist); A is false (or does not exist) and B is true (or exists); or both A and B are true (or exist).

With the development of electronic and intelligent devices, the demand of people for secondary batteries, especially for high energy density secondary batteries, is becoming more and more urgent. Taking a lithium-ion battery as an example, the gradual increase in energy density is often accompanied with the intensification of a potential safety hazard. There are several main aspects: first, aluminum foil, as a positive current collector, has a large face covered with a positive active material but has an end face prone to burrs, which increases the probability of short circuiting, and then increases the probability of catching a fire and other safety problems; and second, there are a plurality of bare metals inside the battery, which is also prone to a short circuit when encountering an extreme external abuse condition.

Existing disclosed patents, documents and the like mainly provide a single protection for internal elements of the battery, such as positive and negative electrode plates and a separator, i.e., pretreating the electrode plates or the separator, followed by assembling same into the battery. However, such treatment method has the following deficiencies: first, treating the positive and negative electrode plates, the separator and the like respectively and then assembling same will double the number of manufacturing procedures and the time consumed, and most importantly, multi-step treatment will reduce the reliability of protection and increase the probability of defects; second, in order not to affect a subsequent process, such as a tab welding process, a special protection for tabs is required before the method is implemented, which affects the production efficiency and reduces the yield; third, through the method, cut-off positions of the electrode plates and a weld zone generated by the subsequent process cannot be protected, so the problem of a potential safety hazard of structures of this part cannot be eliminated; and fourth, the problem of corrosion of an inner wall of a top cap cannot be solved, the inner wall of the top cap, especially an explosion-proof port, will be directly exposed to an environment of an electrolytic solution, and is prone to corrosion in a later electrical cycle.

Therefore, in existing industrialized production, it becomes difficult to find an efficient and low-cost method that can simultaneously form a plurality of protective structures inside the battery.

This application provides a protection method to protect existing battery components including an electrode assembly and a top cap assembly, which can simultaneously form protective layers on surfaces of the battery components for efficient insulation protection, thereby reducing the probability of short circuiting, improving the safety of the battery, preventing corrosion, and improving the reliability of later service of the battery.

In an implementation of this application, this application provides a protection method for battery components. The battery components include an electrode assembly and a top cap assembly. The method includes:
step (1): put the battery components into a cavity, and vacuumize the cavity to 100 kPa or below, optionally, 100 Pa or below;
step (2): introduce a first reactant into the cavity until a pressure rises by 1 Pa or above, and optionally, rises by 1 kPa or above, and keeping the pressure for 1 ms or above, optionally, 0.1 s to 600 s; and optionally,
step (3): vacuumize the cavity to 100 kPa or below, optionally, 100 Pa or below; and
step (4): introduce a second reactant into the cavity until a pressure rises by 1 Pa or above, and optionally, rises by 1 kPa or above, and keeping the pressure for 1 ms or above, optionally, 0.1 s to 600 s,
so that protective layers are formed on surfaces of the battery components.

The second reactant can react with the first reactant to form protective layers.

Although the mechanism is not yet clear, the applicant unexpectedly found that: in this application, the surfaces of the battery components including the electrode assembly and the top cap assembly are protected through a gas-solid interface reaction technology. First, the method simultaneously treats the electrode assembly and the top cap assembly to avoid multiplication of the number of manufacturing procedures and the time consumed, which may not only avoid the problem of protection reliability reduction caused by multi-step treatment, but also slow down corrosion of an inner wall of a top cap; and second, the method may treat a weld zone of the electrode assembly and the top cap assembly to reduce the probability of short circuiting.

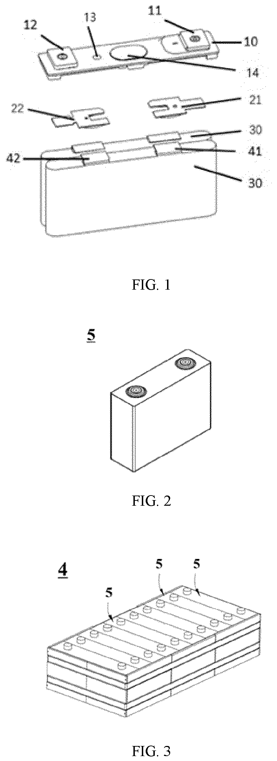

FIG. 1 is an exploded view of battery components according to an implementation of this application. Referring to FIG. 1, the battery components include an electrode assembly 30, positive and negative tabs 41 and 42, positive and negative adapter plates 21 and 22, and a top cap assembly 10. The top cap assembly 10 includes positive and negative terminals 11 and 12, a liquid injection port 13 and an explosion-proof valve 14. The electrode assembly 30 is formed through a process of winding or stacking a positive electrode plate, a negative electrode plate and a separator.

In an embodiment of this application, the battery components are formed by welding the electrode assembly 30, the positive and negative tabs 41 and 42, the positive and negative adapter plates 21 and 22, and the top cap assembly 10. For example, first, the electrode assembly 30 is welded to the positive and negative tabs 41 and 42 respectively; then, the positive and negative tabs 41 and 42 are welded to the positive and negative adapter plates 21 and 22 respectively; and finally, the positive and negative adapter plates 21 and 22 are welded to the positive and negative terminals 11 and 12 of the top cap assembly 10 respectively to obtain the battery components.

In some implementations, the electrode assembly 30 is provided with the positive and negative tabs 41 and 42. That is, the electrode assembly 30 and the positive and negative tabs 41 and 42 are of an integrated structure.

In some implementations, the positive and negative tabs 41 and 42 are an aluminum tab and a copper tab respectively. The positive and negative adapter plates 21 and 22 are an aluminum adapter plate and a copper adapter plate respectively.

In some implementations, surfaces of the battery components include an inner wall of the top cap assembly 10, end faces of the positive and negative electrode plates, an edge of the separator, surfaces of the positive and negative tabs 41 and 42, respective welds between the positive and negative tabs 41 and 42 and the positive and negative adapter plates 21 and 22, surfaces of the positive and negative adapter plates 21 and 22, and respective welds between the positive and negative adapter plates 21 and 22 and the positive and negative terminals 11 and 12 of the top cap assembly 10.

In some implementations, the first reactant includes at least one of a gaseous aluminum compound, silicon compound, tin compound, germanium compound, chromium compound, boron compound, titanium compound, vanadium compound, zinc elementary substance, zinc compound, zirconium compound, hafnium compound and tantalum compound; and optionally, includes at least one of gaseous AlCl₃, trimethylaluminum, Al(CH₃)₂Cl, Al(C₂H₅)₃, Al(OC₂H₅)₃, (CH₃)₂AlOCH(CH₃)₂, (CH₃CH₂)₂AlOC₂H₅, Al(CH₃)₂OC₂H₅, Al(N(C₂H₅)₂)₃, Al(N(CH₃)₂)₃, SiCl₄, SiCl₂H₂, Si₂Cl₆, Si(OC₂H₅)₂H₂, Si₂H₆, Si(OCH₂CH₃)₄, Si(OCH₃)₄, SiH(OCH₃)₃, SiH(OC₂H₅)₃, (CH₃)₂Si(OCH₃)₂, Si(NCO)₄, Si(OC₂H₅)₄, H₂N(CH₂)₃Si(OC₂H₅)₃, CH₂=CHSi(OCH₃)₃, (CH₂=CH)₃SiOCH₃, ((CH₃)₃CO)₃SiOH, (CH₃CH₂C(CH₃)₂O)₃SiOH, SiH[N(CH₃)₂]₃, SiH₂[N(CH₃)₂]₂, SiH₂[NH(C₄H₉)]₂, SiH₂[N(C₂H₅)₂]₂, SiH₂[NC₂H₅CH₃]₂, SiH₃N(C₄H₉)₂, [Si(NHC₂H₅)₃]₂, Si(NHC₂H₅)₄, SiH₃N(C₃H₇)₂, [SiH₂N(C₃H₇)₂]₂, Si(N(CH₃)₂)₄, (CH₃)₃SiN(CH₃)₂, C₇H₁₇NSi, C₈H₂₀N₂Si, C₈H₁₇NO₂Si, C₇H₁₈N₂O₂Si, SiCl₃H, SnCl₄, GeCl₃, CrO₂Cl₂, BBr₃, TiF₄, TiCl₄, TiI₄, Ti(OCH₃)₄, Ti(OC₂H₅)₄, Ti(N(CH₃)₂)₄, Ti(N(C₂H₅)₂)₄, Ti(N(CH₃)(C₂H₅))₄, VOCl₃, Zn, ZnCl₂, Zn(CH₃)₂, Zn(C₂H₅)₂, ZnI₂, ZrCl₄, ZrI₄, Zr(N(CH₃)₂)₄, Zr(N(C₂H₅)₂)₄, Zr(N(CH₃)(C₂H₅))₄, HfCl₄, HfI₄, Hf(NO₃)₄, Hf(N(CH₃)(C₂H₅))₄, Hf(N(CH₃)₂)₄, Hf(N(C₂H₅)₂)₄, TaCl₅, TaF₅, TaI₅, Ta(O(C₂H₅))₅, Ta(N(CH₃)₂)₅, Ta(N(C₂H₅)₂)₅ and TaBr₅.

In an embodiment of this application, the first reactant is introduced in a gaseous form. If the first reactant is a solid or liquid at normal temperature, the first reactant may be turned into a gas according to the following methods: heating, magnetron sputtering, etc.

In some implementations, the second reactant includes at least one of, and/or plasma of at least one of H₂O, O₂, O₃, H₂, S, (NH₄)₂S, H₂Se, Se, H₂Te, Te, HF, TiF₄, TaF₅, C₂H₄, CHCl₃, H₂O₂, NO₂, N₂O, NH₃, N₂H₄, HCOOH, CH₃COOH and H₂S.

By selecting the first reactant and the second reactant, the ingredients of the protective layers may be controlled, and the protective layers are uniform and dense, and have a strong bonding force with substrates, thereby reducing the probability of internal corrosion and short circuiting of the secondary battery.

In the implementations of this application, the substrates refer to the surfaces of the battery components.

In some implementations, in steps (1) to (4), a temperature of the cavity is maintained between 0°C and 200°C. The temperature of the cavity is maintained within a given range, and thus adapted to physical property parameters of specific reactants.

In some implementations, steps (1) to (4) are repeated 1 to 100,000 times. By controlling the times of repetition of steps (1) to (4), a thickness of the protective layers may be controlled.

In some implementations, steps (1) to (2) are first repeated 1 to 10 times, and then steps (1) to (4) are repeated 1 to 100,000 times. By first repeating steps (1) to (2), water of the battery components may be fully utilized as a reactant.

In some implementations, the first reactant and the second reactant are introduced by a carrier gas, and the carrier gas includes at least one of nitrogen, argon, carbon dioxide and helium. By introducing the first reactant and the second reactant through the carrier gas, the reactants may enter the cavity more smoothly.

In some implementations, prior to step (1), the protection method further includes a step of pretreating surfaces of the battery components, the step including introducing at least one of, and/or plasma of at least one of Ar, N₂, H₂O, O₂, O₃, H₂, S, (NH₄)₂S, H₂Se, Se, H₂Te, Te, HF, TiF₄, TaF₅, C₂H₄, CHCl₃, H₂O₂, NO₂, N₂O, NH₃, N₂H₄, HCOOH, CH₃COOH and H₂S into the cavity.

In order to further increase the bonding force between the protective layers and the substrates, pretreament may be performed. As pretreatment, prior to the formation of the protective layers, this application performs plasma treatment of gases including oxygen, water or nitrogen on the surfaces of the battery components, so that organic compound monomers are iso-ionized to perform surface treatment, corona discharge treatment, UV irradiation treatment, ozone treatment, etc., which is conducive to the formation of a compound layer with high bonding strength. The activity and number of reactive groups may be adjusted according to the treatment intensity and time.

In some implementations, the step of pretreating may include adjusting a gas type to clean a to-be-deposited surface, including washing with plasma such as Ar, N₂, H₂ and O₂, for example, washing with plasma of N₂ that is generated by a radio frequency plasma gun with a power ranging from 10 W to 1000 W and a frequency of 13.56 MHz for 1 s to 60 s.

In some implementations, the protective layers are formed at junctions of the tabs 41 and 42 and the adapter plates 21 and 22, junctions of the adapter plates 21 and 22 and the top cap assembly 10, an inner wall of the top cap assembly 10, the adapter plates 21 and 22, and a peripheral surface of the electrode assembly 30.

In some implementations, the protective layers are formed on the inner wall of the top cap assembly 10, end faces of the positive and negative electrode plates, an edge of the separator, surfaces of the positive and negative tabs 41 and 42, respective welds between the positive and negative tabs 41 and 42 and the positive and negative adapter plates 21 and 22, surfaces of the positive and negative adapter plates 21 and 22, and respective welds between the positive and negative adapter plates 21 and 22 and the positive and negative terminals 11 and 12 of the top cap assembly 10.

The protective layers may cover the surface of the electrode assembly, including defects such as burrs and protruding points on the surface, thereby reducing potential safety hazards; and the protective layers may also cover the inner wall of the top cap assembly, thereby alleviating the corrosion problem of the top cap assembly. Additionally, the protective layers may cover surfaces of welds between all portions, thereby reducing heat generated during short-circuited lapping to reduce potential safety hazards.

In some implementations, the protective layers include at least one of carbides, nitrides, sulfides, oxides, fluorides, selenides and tellurides of aluminum, silicon, tin, germanium, chromium, boron, titanium, vanadium, zinc, zirconium, hafnium or tantalum, and optionally include at least one of aluminum oxides, silicon oxides, silicon nitrides, titanium oxides and zinc oxides. By controlling the composition of the protective layers, the protective layers may be more uniform and denser, and the bonding force between the protective layers and the substrates is increased.

In some implementations, after step (2) and/or step (4), the protection method further includes a step of purging the battery components using a purging gas, the purging gas including at least one of N₂, Ar, He, CO₂ and the second reactant. Through the step of purging, the purity and bonding force of the protective layers may be further increased.

In some implementations, the step of purging includes a step of introducing the purging gas after introducing the first reactant and/or the second reactant, and pumping same out. Purging parameters include: a ventilation flow rate related to a battery size, which may be 0.01 to 1000 sccm, and an introduction time, which is optionally 0.1 ms to 120 min.

In some implementations, the protective layers have a thickness ranging from 1 nm to 1000 µm, optionally, 50 nm to 500 nm. By controlling the protective layers within an appropriate thickness range, it has almost no effect on the overall mass energy density and volume energy density of the secondary battery while providing insulation protection.

In some implementations, the protection method further includes a step of aftertreating the protective layers, the step including temperature annealing treatment, plasma annealing treatment or optical radiation annealing treatment in a specific atmosphere. The specific atmosphere includes at least one of, and/or plasma of at least one of pyridine, N₂, Ar, He, CO₂ and the second reactant. Through the step of aftertreating, the quality of the protective layers may be further improved.

In some implementations, temperature annealing treatment includes constant-temperature (80 to 120°C) annealing (10 min to 12 h), high-temperature and low-temperature alternating annealing (the high temperature may be 80 to 120°C, the low temperature may be 25 to 80°C, and the treatment time is 10 min to 12 h), etc.

In some implementations, plasma annealing treatment includes direct-current pulse plasma, radio frequency plasma and electron cyclotron resonance plasma treatment, with a power generally ranging from 5 W to 2000 W and a treatment time generally ranging from 1 s to 120 s.

In some implementations, optical radiation annealing treatment includes laser annealing, which is specifically characterized by continuous fiber laser, with a power Pₘₐₓ = 5 W, a focusing spot r = 200 µm, a scanning speed ranging from 0.01 mm/s to 1 mm/s, and a cumulative treatment time per unit area ranging from 1 s to 300 s.

In an implementation of this application, a protection device for battery components is further provided. The battery components include an electrode assembly and a top cap assembly. The protection device includes:
a cavity, configured to accommodate the battery components;
a first reactant tank, configured to store a first reactant;
a second reactant tank, configured to store a second reactant;
a vacuum pump;
a pressure gauge, configured to detect a pressure of the cavity in real time; and
a flow adjustment valve, configured to adjust flows of the first reactant and the second reactant.

The second reactant can react with the first reactant to form protective layers.

The first reactant tank and the second reactant tank communicate with the cavity respectively to introduce the first reactant and the second reactant into the cavity; and the vacuum pump communicates with the cavity to vacuumize the cavity.

Through the device of this application, first, protective reaction requirements may be realized and include: temperature adjustment of the battery components, real-time gas pressure detection, adjustment of the amount of each reactant, and high gas tightness of a pipeline; and second, the device is simple, thereby simplifying a protection process of the battery components, at the same time, improving the efficiency, reducing costs, and facilitating industrialized production.

In some implementations, the device further includes a pressure gauge configured to detect pressures of the first reactant tank and the second reactant tank in real time.

In some implementations, the number of the reactant tanks may be increased or decreased according to a type of a reactant. For example, the device may further include a third reactant tank for storing a third reactant for deposition.

Additionally, the following describes a secondary battery, a battery module, a battery pack and an electrical apparatus according to this application with due reference to the drawings.

In an implementation of this application, a secondary battery is provided. The secondary battery includes battery components obtained by protection through the protection method according to the first aspect of this application.

Typically, the secondary battery includes a positive electrode plate, a negative electrode plate, an electrolyte and a separator. In the charging and discharging processes of the battery, active ions are intercalated and deintercalated between the positive electrode plate and the negative electrode plate back and forth. The electrolyte serves to conduct ions between the positive electrode plate and the negative electrode plate. The separator is disposed between the positive electrode plate and the negative electrode plate, and primarily serves to prevent a short circuit between a positive electrode and a negative electrode while allowing ions to pass through.

### [Positive electrode plate]

The positive electrode plate includes a positive current collector and a positive electrode film layer disposed on at least one surface of the positive current collector, and the positive electrode film layer includes a positive active material.

As an example, the positive current collector is provided with two opposite surfaces in a thickness direction of the positive current collector, and the positive electrode film layer is disposed on either or both of the two opposite surfaces of the positive current collector.

In some implementations, the positive current collector may be a metal foil or a composite current collector. For example, the metal foil may be an aluminum foil. The composite current collector may include a polymer material substrate and a metal layer formed on at least one surface of the polymer material substrate. The composite current collector may be formed by forming a metal material (aluminum, aluminum alloy, nickel, nickel alloy, titanium, titanium alloy, silver, silver alloy, and the like) on the polymer material substrate (such as polypropylene (PP), polyethylene terephthalate (PET), polybutylene terephthalate (PBT), polystyrene (PS), or polyethylene (PE)).

In some implementations, the positive active material may be a positive active material well known for use in a battery in the art. As an example, the positive active material may include at least one of the following materials: olivine-structured lithium-containing phosphate, lithium transition metal oxide, and a modified compound thereof. However, this application is not limited to such materials, and other materials usable as a positive active material of a battery may further be used, such as a positive material for a sodium-ion battery. Of such positive active materials, one may be used alone, or at least two may be used in combination. Examples of the lithium transition metal oxide may include, but are not limited to, at least one of lithium cobalt oxide (such as LiCoO₂), lithium nickel oxide (such as LiNiO₂), lithium manganese oxide (such as LiMnO₂, and LiMn₂O₄), lithium nickel cobalt oxide, lithium manganese cobalt oxide, lithium nickel manganese oxide, lithium nickel cobalt manganese oxide (such as LiNi_{1/3}Co_{1/3}Mn_{1/3}O₂ (also referred to as NCM333), LiNi_{0.5}Co_{0.2}Mn_{0.3}O₂ (also referred to as NCM523), LiNi_{0.5}Co_{0.25}Mn_{0.25}O₂ (also referred to as NCM211), LiNi_{0.6}Co_{0.2}Mn_{0.2}O₂ (also referred to as NCM622), LiNi_{0.8}Co_{0.1}Mn_{0.1}O₂ (also referred to as NCM811), lithium nickel cobalt aluminum oxide (such as LiNi_{0.85}Co_{0.15}Al_{0.05}O₂), a modified compound thereof, or the like. Examples of the olivine-structured lithium-containing phosphate may include, but are not limited to, at least one of lithium iron phosphate (such as LiFePO₄ (briefly referred to as LFP)), a composite of lithium iron phosphate and carbon, lithium manganese phosphate (such as LiMnPO₄), a composite of lithium manganese phosphate and carbon, lithium manganese iron phosphate, or a composite of lithium manganese iron phosphate and carbon.

In some implementations, the positive electrode film layer further optionally includes a binder. As an example, the binder may include at least one of polyvinylidene fluoride (PVDF), polytetrafluoroethylene (PTFE), poly(vinylidene fluoride-co-tetrafluoroethylene-co-propylene), poly(vinylidene fluoride-co-hexafluoropropylene-co-tetrafluoroethylene, poly(tetrafluoroethylene-co-hexafluoropropylene), and fluorinated acrylate resin.

In some implementations, the positive electrode film layer further optionally includes a conductive agent. As an example, the conductive agent may include at least one of superconducting carbon, acetylene black, carbon black, Ketjen black, carbon dots, carbon nanotubes, graphene and carbon nanofibers.

In some implementations, the positive electrode plate may be prepared according to the following method: dispersing the foregoing ingredients for preparing the positive electrode plate, such as the positive active material, the conductive agent, the binder and any other ingredients into a solvent (such as N-methylpyrrolidone) to form a positive slurry; and coating the positive current collector with the positive slurry, and performing procedures such as drying and cold calendering to obtain the positive electrode plate.

### [Negative electrode plate]

The negative electrode plate includes a negative current collector and a negative electrode film layer disposed on at least one surface of the negative current collector, and the negative electrode film layer includes a negative active material.

As an example, the negative current collector is provided with two opposite surfaces in a thickness direction of the negative current collector, and the negative electrode film layer is disposed on either or both of the two opposite surfaces of the negative current collector.

In some implementations, the negative current collector may be a metal foil or a composite current collector. For example, as the metal foil, a copper foil may be used. The composite current collector may include a polymer material substrate and a metal layer formed on at least one surface of the polymer material substrate. The composite current collector may be formed by forming a metal material (copper, copper alloy, nickel, nickel alloy, titanium, titanium alloy, silver, silver alloy, and the like) on the polymer material substrate (such as polypropylene (PP), polyethylene terephthalate (PET), polybutylene terephthalate (PBT), polystyrene (PS), or polyethylene (PE)).

In some implementations, the negative active material may be a negative active material well known for use in a battery in the art. As an example, the negative active material may include at least one of the following materials: artificial graphite, natural graphite, soft carbon, hard carbon, a silicon-based material, a tin-based material, lithium titanium oxide, a lithium metal negative electrode, or the like. The silicon-based material may be at least one selected from simple-substance silicon, a silicon-oxygen compound, a silicon-carbon composite, a silicon-nitrogen composite, and silicon alloy. The tin-based material may be at least one selected from simple-substance tin, tin-oxygen compound, or tin alloy. However, this application is not limited to such materials, and other conventional materials usable as a negative active material of a battery may further be used. Of such negative active materials, one may be used alone, or at least two may be used in combination.

In some implementations, the negative electrode film layer further optionally includes a binder. The binder may be at least one selected from styrene-butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA), and carboxymethyl chitosan (CMCS).

In some implementations, the negative electrode film layer further optionally includes a conductive agent. The conductive agent may be at least one selected from superconductive carbon, acetylene black, carbon black, Ketjen black, carbon dots, carbon nanotubes, graphene, and carbon nanofibers.

In some implementations, the negative electrode film layer further optionally includes other agents, such as a thickener (for example, sodium carboxymethyl cellulose (CMC-Na)).

In some implementations, the negative electrode plate may be prepared according to the following method: dispersing the foregoing ingredients for preparing the negative electrode plate, such as the negative active material, the conductive agent, the binder, and any other ingredients into a solvent (such as deionized water) to form a negative slurry; and coating a negative current collector with the negative slurry, and performing procedures such as drying and cold calendering to obtain the negative electrode plate.

### [Electrolyte]

The electrolyte serves to conduct ions between the positive electrode plate and the negative electrode plate. The type of the electrolyte is not particularly limited in this application, and may be selected as required. For example, the electrolyte may be in a liquid state or gel state, or all solid state.

In some implementations, the electrolyte is an electrolytic solution. The electrolytic solution includes an electrolyte salt and a solvent.

In some implementations, the electrolyte salt may be at least one selected from lithium hexafluorophosphate, lithium tetrafluoroborate, lithium perchlorate, lithium hexafluoroarsenate, lithium bisfluorosulfonimide, lithium bistrifluoromethanesulfonimide, lithium trifluoromethanesulfonate, lithium difluorophosphate, lithium difluoro(oxalato)borate, lithium bis(oxalate)borate, lithium difluoro(bisoxalato)phosphate and lithium tetrafluoro(oxalato)phosphate.

In some implementations, the solvent may be at least one selected from ethylene carbonate, propylene carbonate, ethyl methyl carbonate, diethyl carbonate, dimethyl carbonate, dipropyl carbonate, methyl propyl carbonate, ethylene propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, methyl sulfonyl methane, ethyl methyl sulfone, and (ethylsulfonyl)ethane.

In some implementations, the electrolytic solution further optionally includes an additive. For example, the additive may include a negative film-forming additive and a positive film-forming additive. The additive may further include an additive capable of improving specified performance of the battery, for example, an additive for improving overcharge performance of the battery, or an additive for improving high- or low-temperature performance of the battery.

### [Separator]

In some implementations, the secondary battery further includes a separator. The type of the separator is not particularly limited in this application, and may be any well-known separator with a porous structure that has good chemical stability and mechanical stability.

In some implementations, the material of the separator may be at least one selected from glass fibers, a nonwoven fabric, polyethylene, polypropylene and polyvinylidene fluoride. The separator may be a single-layer film, and may also be a multilayer composite film, without being particularly limited. When the separator is the multilayer composite film, materials of layers may be the same or different, without being particularly limited.

In some implementations, the positive electrode plate, the negative electrode plate and the separator may be made into an electrode assembly through a winding process or a stacking process.

In some implementations, the secondary battery may include an outer package. The outer package may be configured to package the foregoing electrode assembly and the electrolyte.

In some implementations, the outer package of the secondary battery may be a hard shell such as a hard plastic shell, an aluminum shell, a steel shell, or the like. The outer package of the secondary battery may also be a soft package such as a pouch-type soft package. The soft package may be made of plastic such as polypropylene, polybutylene terephthalate, or polybutylene succinate.

The shape of the secondary battery is not particularly limited in this application, and may be cylindrical, prismatic or any other shape. For example, FIG. 2 is an exemplary secondary battery 5 of a prismatic structure. Additionally, the secondary battery of this application is not limited to a hard shell battery, and may further includes a soft pack battery and other battery forms.

In some implementations, the outer package may include a shell and a top cap assembly 10. The shell may include a bottom plate and side plates connected to the bottom plate, and an accommodating cavity is defined by the bottom plate and the side plates. The shell is provided with an opening communicating with the accommodating cavity, and the top cap assembly 10 can cover the opening to close the accommodating cavity. The electrode assembly 30 is packaged in the accommodating cavity. The electrode assembly 30 is infiltrated with the electrolytic solution. There may be one or more electrode assemblies 30 in the secondary battery 5, which may be selected by a person skilled in the art according to specific practical needs.

In some implementations, the secondary battery may be assembled into a battery module, there may be one or more secondary batteries in the battery module, and the specific number may be selected by a person skilled in the art according to the application and capacity of the battery module.

FIG. 3 is an exemplary battery module 4. Referring to FIG. 3, in the battery module 4, a plurality of secondary batteries 5 may be sequentially arrayed in a length direction of the battery module 4. Certainly, the plurality of secondary batteries 5 may also be laid out in any other manners. Further, the plurality of secondary batteries 5 may be fixed through a fastener.

Optionally, the battery module 4 may further include a housing with an accommodating space, and the plurality of secondary batteries 5 are accommodated in the accommodating space.

In some implementations, the foregoing battery module may further be assembled into a battery pack, there may be one or more battery modules in the battery pack, and the specific number may be selected by a person skilled in the art according to the application and capacity of the battery pack.

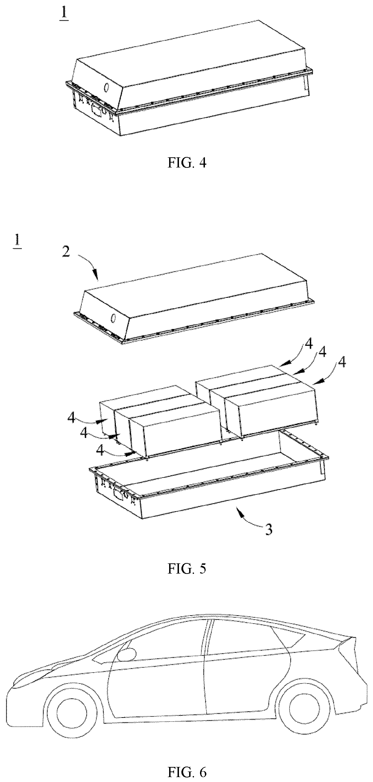

FIG. 4 and FIG. 5 are an exemplarya battery pack 1. Referring to FIG. 4 and FIG. 5, the battery pack 1 may include a battery box and a plurality of battery modules 4 disposed in the battery box. The battery box includes an upper box body 2 and a lower box body 3, and the upper box body 2 may cover the lower box body 3 to form a closed space for accommodating the battery modules 4. The plurality of battery modules 4 may be laid out in the battery box in any manners.

Additionally, this application further provides an electrical apparatus. The electrical apparatus includes at least one of the secondary battery, the battery module or the battery pack provided by this application. The secondary battery, the battery module and the battery pack may be used as a power supply of the electrical apparatus, and may also be used as an energy storage unit of the electrical apparatus. The electrical apparatus may include, but not limited to, a mobile device (such as a mobile phone or a laptop computer), an electric vehicle (such as a battery electric vehicle, a hybrid electric vehicle, a plug-in hybrid electric vehicle, an electric bicycle, an electric scooter, an electric golf cart, or an electric truck), an electric train, a ship and a satellite, an energy storage system, or the like.

As the electrical apparatus, the secondary battery, the battery module or the battery pack may be selected according to the use needs of the electrical apparatus.

FIG. 6 is an exemplary electrical apparatus. The electrical apparatus is a battery electric vehicle, a hybrid electric vehicle, a plug-in hybrid electric vehicle, or the like. In order to meet the needs of the electrical apparatus for high power and high energy density of a secondary battery, a battery pack or a battery module may be used.

As another example, a device may be a mobile phone, a tablet computer, a laptop computer, or the like. The device is typically required to be thin and light, and may use the secondary battery as a power supply.

### Embodiment

The embodiments of this application are illustrated below in conjunction with the drawings. The embodiments described below are exemplary merely for the purpose of explaining this application, and shall not be construed as limiting this application. Where specific technologies or conditions are not indicated in the embodiments, follow technologies or conditions described in documents in the art or a product specification. Reagents or instruments used without indication of manufacturers are conventional products that are commercially available.

### Embodiment 1

### [Preparation of positive electrode plate]

Fully stir and mix LiNi_{1/3}Co_{1/3}Mn_{1/3}O₂ (NCM333) as a positive active material, conductive carbon black, and polyvinylidene fluoride (PVDF) as a binder in an appropriate amount of an N-methylpyrrolidone (NMP) solvent at a mass ratio of 93:2:5 to form an even positive slurry; and coat 12-µm thick aluminum foil with the positive slurry, and perform procedures such as drying to obtain a positive electrode plate.

### [Preparation of negative electrode plate]

Fully stir and mix graphite as a negative active material, conductive carbon black, sodium carboxymethylcellulose (CMC) as a thickener, and a styrene-butadiene rubber (SBR) emulsion as a binder in an appropriate amount of deionized water at a mass ratio of 96.5:1.0:1.0:1.5 to form an even negative slurry; and coat 8-µm thick copper foil with the negative slurry, and perform procedures such as drying to obtain a negative electrode plate.

### [Preparation of battery components including electrode assembly and top cap assembly]

Sequentially stack the positive electrode plate, a separator (a 20-µm thick PP/PE/PP composite film), and the negative electrode plate, wind same to obtain an electrode assembly with an aluminum positive tab and a copper negative tab, weld the positive and negative tabs to an aluminum positive adapter plate and a copper negative adapter plate respectively, and weld the positive and negative adapter plates to positive and negative terminals of a top cap assembly respectively to obtain battery components including the electrode assembly and the top cap assembly.

### [Protecting surfaces of battery components]

Protect surfaces of battery components through a protection device, the protection device including a cavity configured to accommodate the battery components; a first reactant tank configured to store a first reactant, a second reactant tank configured to store a second reactant, where the first and second reactant tanks can communicate with the cavity respectively to introduce the first and second reactants into the cavity; a vacuum pump capable of communicating with the cavity to vacuumize the cavity; a pressure gauge configured to detect a pressure inside the cavity in real time; and a flow adjustment valve configured to adjust flows of the first reactant and the second reactant. Protecting the surfaces of the battery components includes the following steps:
step (1): putting the battery components into the cavity, controlling a temperature of the cavity at 70°C, and vacuumizing the cavity to 50 Pa;
step (2): introducing gaseous trimethylaluminum as the first reactant into the cavity until a pressure rises by 50 Pa for 10 s;
step (3): vacuumizing the cavity to 50 Pa; and
step (4): introducing water vapor as the second reactant into the cavity until a pressure rises by 50 Pa for 5 s; and
repeating steps (1) to (4) a total of 500 times to form nanometer-thick aluminum oxide protective layers on the surfaces of the battery components.

### [Preparation of finished secondary battery]

Weld the top cap assembly in the foregoing protected battery components to a shell through laser welding to obtain a secondary battery without liquid injection, inject an electrolytic solution (EC:EMC volume ratio of 3:7, LiPF₆ of 1 mol/L) into the secondary battery without liquid injection, and perform procedures such as sealing, standing, hot and cold calendering, and chemical formation to obtain a lithium-ion secondary battery.

### Embodiments 2-11

Secondary batteries in Embodiments 2-11 are prepared by a method similar to the preparation method for the secondary battery in Embodiment 1, except that in the protection of the surfaces of the battery components, conditions are adjusted. For details, see Table 1.

### Embodiment 12

A secondary battery in Embodiment 12 is prepared by a method similar to the preparation method for the secondary battery in Embodiment 1, except that protection of the surfaces of the battery components includes the following steps:
step (1): putting the battery components into the cavity, controlling a temperature of the cavity at 70°C, and vacuumizing the cavity to 100 Pa;
step (2): introducing gaseous tris(dimethylamino)silane (TDMAS) as a first reactant into the cavity until a pressure rises by 100 Pa for 1 s;
step (3): vacuumizing the cavity to 50 Pa; and
step (4): introducing plasma, which is realized by a mixed gas of Ar and O₂ through radio-frequency discharge of 13.56 MHz, with a radio-frequency power of 1000 W, an Ar carrier gas flow rate of 80 mL/min, and an O₂ flow rate of 100 mL/min; and
repeating steps (1) to (4) a total of 10000 times to form nanometer and micrometer-thick silicon oxide protective layers on the surfaces of the battery components.

### Embodiment 13

A secondary battery in Embodiment 13 is prepared by a method similar to the preparation method for the secondary battery in Embodiment 12, except that in the protection of the surfaces of the battery components, process conditions are adjusted. For details, see Table 1.

### Embodiment 14

A secondary battery in Embodiment 14 is prepared by a method similar to the preparation method for the secondary battery in Embodiment 1, except that in the protection of the surfaces of the battery components, first, steps (1) to (2) are repeated 10 times to use water of the battery components as a second reactant, and then steps (1) to (4) are repeated 6990 times, in which water vapor is used as a second reactant. For other process conditions, see Table 1.

### Embodiment 15

A secondary battery in Embodiment 15 is prepared by a method similar to the preparation method for the secondary battery in Embodiment 1, except that prior to the protection of the surfaces of the battery components, a step of pretreating the surfaces of the battery components is performed, including washing with plasma of N₂ that is generated by a radio frequency plasma gun with a power of 150 W and a frequency of 13.56 MHz for 10 s.

### Embodiment 16

A secondary battery in Embodiment 16 is prepared by a method similar to the preparation method for the secondary battery in Embodiment 1, except that after step (2) and step (4), a step of introducing a purging gas and pumping same out is added. Purging parameters include: the purging gas of N₂, a flow rate of 1 sccm, and an introduction time of 10 s. For other process conditions, see Table 1.

### Embodiment 17

A secondary battery in Embodiment 17 is prepared by a method similar to the preparation method for the secondary battery in Embodiment 1, except that after the completion of preparation, the protective layers are treated at a high temperature of 105°C for 8 h.

### Comparative Embodiment 1

A secondary battery in Comparative Embodiment 1 is prepared by a method similar to the preparation method for the secondary battery in Embodiment 1, except that the surfaces of the battery components are not protected.

### Parameter test

### 1. Thickness of protective layers

Use a scanning electron microscope ZEISSsigma300 to randomly select ten different positions in a test sample for testing, and obtain an average value, so as to obtain a thickness of the protection layers.

### 2. Composition of protective layers

Use ZEISSsigma300 matched energy-dispersive x-ray spectroscopy (EDS) to perform elemental analysis on a surface of a related area.

### 3. Resistance value

Use a conventional commercial G2A diaphragm resistor to randomly select ten different positions in a test sample for testing, and obtain an average value.

Test the secondary batteries obtained in the foregoing Embodiments and Comparative Embodiments respectively according to the foregoing process. For specific values, see Table 2.

**Table 1**

| Embodiment | First reactant | Second reactant | Reaction or deposition temperature (°C) | Number of cycles |
|---|---|---|---|---|
| Embodiment 1 | Trimethylaluminum | Water vapor | 70 | 500 |
| Embodiment 2 | Trimethylaluminum | Water vapor | 80 | 2000 |
| Embodiment 3 | Trimethylaluminum | Water vapor | 65 | 5000 |
| Embodiment 4 | Trimethylaluminum | Water vapor | 80 | 15000 |
| Embodiment 5 | Silicon tetrachloride | Water vapor | 90 | 3000 |
| Embodiment 6 | Silicon tetrachloride | Water vapor | 80 | 2000 |
| Embodiment 7 | Si(OCH₃)₄ | Ammonia water vapor | 75 | 2000 |
| Embodiment 8 | TiCl₄ | Water vapor | 80 | 4000 |
| Embodiment 9 | Ti(OC₂H₅)₄ | Ammonia water vapor | 70 | 3000 |
| Embodiment 10 | ZnCl₂ | Water vapor | 80 | 3000 |
| Embodiment 11 | Zn(CH₃)₂ | Water vapor | 75 | 2000 |
| Embodiment 12 | Tris(dimethylamino)silane | Oxygen plasma | 70 | 10000 |
| Embodiment 13 | Tris(dimethylamino)silane | Ammonia plasma | 70 | 5000 |
| Embodiment 14 | Trimethylaluminum | Water vapor | 65 | 7000 |
| Embodiment 15 | Trimethylaluminum | Water vapor | 55 | 1000 |
| Embodiment 16 | Trimethylaluminum | Water vapor | 60 | 2000 |
| Embodiment 17 | Trimethylaluminum | Water vapor | 70 | 500 |
| Comparative embodiment | / | / | / | / |

**Table 2**

| Embodiment | Material of protective layers | Thickness (nm) of protective layers | | | | Resistance value (Ω) | |
|---|---|---|---|---|---|---|---|
| | | Inner wall of top cap | Welds of tabs and adapter plates | Positive adapter plate | Negative adapter plate | Inner wall of top cap | Welds of tabs and adapter plates |
| Embodiment 1 | Aluminum oxide | 52 | 61 | 59 | 49 | > 1.0 × 10⁰ | > 1.0 × 10⁰ |
| Embodiment 2 | Aluminum oxide | 218 | 226 | 209 | 213 | > 1.0 × 10³ | > 1.0 × 10³ |
| Embodiment 3 | Aluminum oxide | 501 | 525 | 531 | 498 | > 1.0 × 10⁶ | > 1.0 × 10⁶ |
| Embodiment 4 | Aluminum oxide | 1557 | 1692 | 1489 | 1503 | > 1.0 × 10⁶ | > 1.0 × 10⁶ |
| Embodiment 5 | Silicon oxide | 266 | 247 | 251 | 260 | > 1.0 × 10³ | > 1.0 × 10³ |
| Embodiment 6 | Silicon oxide | 188 | 173 | 195 | 182 | > 1.0 × 10³ | > 1.0 × 10³ |
| Embodiment 7 | Silicon oxide | 808 | 891 | 852 | 901 | > 1.0 × 10⁶ | > 1.0 × 10⁶ |
| Embodiment 8 | Titanium oxide | 203 | 197 | 181 | 186 | > 1.4 × 10³ | > 1.4 × 10³ |
| Embodiment 9 | Titanium oxide | 1203 | 1161 | 1384 | 1422 | > 1.0 × 10⁶ | > 1.0 × 10⁶ |
| Embodiment 10 | Zinc oxide | 414 | 491 | 479 | 458 | > 1.0 × 10⁶ | > 1.0 × 10⁶ |
| Embodiment 11 | Zinc oxide | 179 | 167 | 204 | 186 | > 1.0 × 10³ | > 1.0 × 10³ |
| Embodiment 12 | Silicon oxide | 1029 | 1103 | 984 | 1063 | > 1.0 × 10⁶ | > 1.0 × 10⁶ |
| Embodiment 13 | Silicon nitride | 598 | 630 | 647 | 681 | > 1.0 × 10⁶ | > 1.0 × 10⁶ |
| Embodiment 14 | Aluminum oxide | 560 | 537 | 522 | 629 | > 1.0 × 10⁶ | > 1.0 × 10⁶ |
| Embodiment 15 | Aluminum oxide | 109 | 78 | 102 | 93 | > 1.0 × 10⁰ | > 1.0 × 10⁰ |
| Embodiment 16 | Aluminum oxide | 177 | 147 | 152 | 183 | > 1.0 × 10³ | > 1.0 × 10³ |
| Embodiment 17 | Aluminum oxide | 56 | 69 | 55 | 58 | > 1.0 × 10⁰ | > 1.0 × 10⁰ |
| Comparative Embodiment 1 | \ | \ | \ | \ | \ | \ | \ |

It can be seen from Table 1 and Table 2, battery components including an electrode assembly and a top cap assembly are protected through the protection method according to this application, and integrated treatment is performed on surfaces of the battery components, especially on an inner wall of the top cap assembly and surfaces of welds of tabs and adapter plates, that is, protective layers are formed on the surfaces. The protective layers increase resistance of the surfaces, which may effectively reduce a risk of thermal runaway caused by an internal short circuit of a battery, and at the same time, the protective layers may further reduce corrosion of an internal composition of the battery, such as an electrolytic solution, thereby improving the safety performance of the secondary battery.

It is hereby noted that this application is not limited to the foregoing implementations. The foregoing implementations are merely examples. Any and all implementations with substantively the same constituents or exerting the same effects as the technical ideas hereof without departing from the scope of the technical solutions of this application still fall within the technical scope of this application. In addition, all kinds of variations of the implementations conceivable by a person skilled in the art and any other implementations derived by combining some constituents of the implementations hereof without departing from the scope of the subject-matter of this application still fall within the scope of this application.

## Claims

1. A protection method for battery components that comprise an electrode assembly (30) and a top cap assembly (10), the method comprising:
step (1): putting the battery components into a cavity, and vacuumizing the cavity to 100 kPa or below, optionally, 100 Pa or below;
step (2): introducing a first reactant into the cavity until a pressure rises by 1 Pa or above, and optionally, rises by 1 kPa or above, and keeping the pressure for 1 ms or above, optionally, 0.1 s to 600 s; and optionally,
step (3): vacuumizing the cavity to 100 kPa or below, optionally, 100 Pa or below; and
step (4): introducing a second reactant into the cavity until a pressure rises by 1 Pa or above, and optionally, rises by 1 kPa or above, and keeping the pressure for 1 ms or above, optionally, 0.1 s to 600 s,
so that protective layers are formed on surfaces of the battery components,
wherein the second reactant can react with the first reactant to form the protective layers.

2. The protection method according to claim 1, wherein the first reactant comprises at least one of a gaseous aluminum compound, silicon compound, tin compound, germanium compound, chromium compound, boron compound, titanium compound, vanadium compound, zinc elementary substance, zinc compound, zirconium compound, hafnium compound and tantalum compound; and optionally, comprises at least one of gaseous AlCl₃, trimethylaluminum, Al(CH₃)₂Cl, Al(C₂H₅)₃, Al(OC₂H₅)₃, (CH₃)₂AlOCH(CH₃)₂, (CH₃CH₂)₂AlOC₂H₅, Al(CH₃)₂OC₂H₅, Al(N(C₂H₅)₂)₃, Al(N(CH₃)₂)₃, SiCl₄, SiCl₂H₂, Si₂Cl₆, Si(OC₂H₅)₂H₂, Si₂H₆, Si(OCH₂CH₃)₄, Si(OCH₃)₄, SiH(OCH₃)₃, SiH(OC₂H₅)₃, (CH₃)₂Si(OCH₃)₂, Si(NCO)₄, Si(OC₂H₅)₄, H₂N(CH₂)₃Si(OC₂H₅)₃, CH₂=CHSi(OCH₃)₃, (CH₂=CH)₃SiOCH₃, ((CH₃)₃CO)₃SiOH, (CH₃CH₂C(CH₃)₂PO)₃SiOH, SiH[N(CH₃)₂]₃, SiH₂[N(CH₃)₂]₂, SiH₂[NH(C₄H₉)]₂, SiH₂[N(C₂H₅)₂]₂, SiH₂[NC₂H₅CH₃]₂, SiH₃N(C₄H₉)₂, [Si(NHC₂H₅)₃]₂, Si(NHC₂H₅)₄, SiH₃N(C₃H₇)₂, [SiH₂N(C₃H₇)₂]₂, Si(N(CH₃)₂)₄, (CH₃)₃SiN(CH₃)₂, C₇H₁₇NSi, C₈H₂₀N₂Si, C₈H₁₇NO₂Si, C₇H₁₈N₂O₂Si, SiCl₃H, SnCl₄, GeCl₃, CrO₂Cl₂, BBr₃, TiF₄, TiCl₄, TiI₄, Ti(OCH₃)₄, Ti(OC₂H₅)₄, Ti(N(CH₃)₂)₄, Ti(N(C₂H₅)₂)₄, Ti(N(CH₃)(C₂H₅))₄, VOCl₃, Zn, ZnCl₂, Zn(CH₃)₂, Zn(C₂H₅)₂, ZnI₂, ZrCl₄, ZrI₄, Zr(N(CH₃)₂)₄, Zr(N(C₂H₅)₂)₄, Zr(N(CH₃)(C₂H₅))₄, HfCl₄, HfI₄, Hf(NO₃)₄, Hf(N(CH₃)(C₂H₅))₄, Hf(N(CH₃)₂)₄, Hf(N(C₂H₅)₂)₄, TaCl₅, TaF₅, TaI₅, Ta(O(C₂H₅))₅, Ta(N(CH₃)₂)₅, Ta(N(C₂H₅)₂)₅ and TaBr₅.

3. The protection method according to claim 1 or 2, wherein the second reactant comprises at least one of, and/or plasma of at least one of H₂O, O₂, O₃, H₂, S, (NH₄)₂S, H₂Se, Se, H₂Te, Te, HF, TiF₄, TaF₅, C₂H₄, CHCl₃, H₂O₂, NO₂, N₂O, NH₃, N₂H₄, HCOOH, CH₃COOH and H₂S.

4. The protection method according to any one of claims 1 to 3, wherein in steps (1) to (4), a temperature of the cavity is maintained between 0°C and 200°C.

5. The protection method according to any one of claims 1 to 4, wherein steps (1) to (4) are repeated 1 to 100,000 times.

6. The protection method according to any one of claims 1 to 4, wherein steps (1) to (2) are first repeated 1 to 10 times, and then steps (1) to (4) are repeated 1 to 100,000 times.

7. The protection method according to any one of claims 1 to 6, wherein the first reactant and the second reactant are introduced by a carrier gas, and the carrier gas comprises at least one of nitrogen, argon, carbon dioxide and helium.

8. The protection method according to any one of claims 1 to 7, wherein prior to step (1), the protection method further comprises a step of pretreating surfaces of the battery components, the step comprising introducing at least one of, and/or plasma of at least one of Ar, N₂, H₂O, O₂, O₃, H₂, S, (NH₄)₂S, H₂Se, Se, H₂Te, Te, HF, TiF₄, TaF₅, C₂H₄, CHCl₃, H₂O₂, NO₂, N₂O, NH₃, N₂H₄, HCOOH, CH₃COOH and H₂S into the cavity.

9. The protection method according to any one of claims 1 to 8, wherein the battery components further comprise tabs (41, 42) and adapter plates (21, 22), and the protective layers are formed at junctions of the tabs (41, 42) and the adapter plates (21, 22), junctions of the adapter plates (21, 22) and the top cap assembly (10), an inner wall of the top cap assembly (10), the adapter plates (21, 22), and a peripheral surface of the electrode assembly (30).

10. The protection method according to any one of claims 1 to 9, wherein the protective layers comprise at least one of carbides, nitrides, sulfides, oxides, fluorides, selenides and tellurides of aluminum, silicon, tin, germanium, chromium, boron, titanium, vanadium, zinc, zirconium, hafnium or tantalum, and optionally comprise at least one of aluminum oxides, silicon oxides, silicon nitrides, titanium oxides and zinc oxides.

11. The protection method according to any one of claims 1 to 10, wherein after step (2) and/or step (4), the protection method further comprises a step of purging the battery components using a purging gas, the purging gas comprising at least one of N₂, Ar, He, CO₂ and the second reactant.

12. The protection method according to any one of claims 1 to 11, wherein the protective layers have a thickness ranging from 1 nm to 1000 µm, optionally, 50 nm to 500 nm.

13. The protection method according to any one of claims 1 to 12, wherein the protection method further comprises a step of aftertreating the protective layers, the step comprising temperature annealing treatment, plasma annealing treatment or optical radiation annealing treatment in a specific atmosphere; and the specific atmosphere comprises at least one of, and/or plasma of at least one of pyridine, N₂, Ar, He, CO₂ and the second reactant.

14. A protection device for battery components that comprise an electrode assembly (30) and a top cap assembly (10), the protection device comprising:
a cavity, configured to accommodate the battery components;
a first reactant tank, configured to store a first reactant;
a second reactant tank, configured to store a second reactant;
a vacuum pump;
a pressure gauge, configured to detect a pressure of the cavity in real time; and
a flow adjustment valve, configured to adjust flows of the first reactant and the second reactant,
wherein the second reactant can react with the first reactant to form protective layers;
the first reactant tank and the second reactant tank communicate with the cavity respectively to introduce the first reactant and the second reactant into the cavity; and the vacuum pump communicates with the cavity to vacuumize the cavity.

15. A secondary battery, comprising battery components obtained by protection through the protection method according to any one of claims 1 to 13.

16. A battery module, comprising the secondary battery according to claim 15.

17. A battery pack, comprising the battery module according to claim 16.

18. An electrical apparatus, comprising at least one of the secondary battery according to claim 15, the battery module according to claim 16, or the battery pack according to claim 17.
